Europäisches Patentamt

European Patent Office

Office européen des brevets

(19)

(11) Veröffentlichungsnummer : **0 111 659**
B1

(12)

# EUROPÄISCHE PATENTSCHRIFT

(45) Veröffentlichungstag der Patentschrift :
30.12.86

(21) Anmeldenummer : 83110114.2

(22) Anmeldetag : 11.10.83

(51) Int. Cl.⁴ : **H 01 L 25/04**, H 01 L 23/48

(54) **Leistungstransistor-Modul.**

(30) Priorität : 10.11.82 DE 3241509

(43) Veröffentlichungstag der Anmeldung :
27.06.84 Patentblatt 84/26

(45) Bekanntmachung des Hinweises auf die Patenterteilung : 30.12.86 Patentblatt 86/52

(84) Benannte Vertragsstaaten :
FR GB IT

(56) Entgegenhaltungen :
WO-A-79 /008 17
DE-A- 2 805 019
Patent Abstracts of Japan Band 5, Nr. 66, 2. Mai 1981
& JP-A-56-15053

(73) Patentinhaber : BROWN, BOVERI & CIE Aktiengesellschaft
Kallstadter Strasse 1
D-6800 Mannheim 31 (DE)

(72) Erfinder : Neidig, Arno, Dr., Dipl.-Phys.
Brühlerweg 42
D-6831 Plankstadt (DE)
Erfinder : Leukel, Bernd, Dipl.-Ing.
Karlsruher Strasse 19
D-6940 Weinheim (DE)
Erfinder : Bergmann, Lutz, Dipl.-Ing.
Benzstrasse 5
D-6840 Lampertheim (DE)

(74) Vertreter : Kempe, Wolfgang, Dr. et al
c/o Brown, Boveri & Cie AG Postfach 351
D-6800 Mannheim 1 (DE)

**Beschreibung**

Die Erfindung bezieht sich auf ein Leistungstransistor-Modul gemäß dem Oberbegriff des Anspruchs 1.

Derartige Leistungstransistor-Module sind allgemein bekannt.

Ausschaltbare Halbleiterbauelemente, wie Transistoren, haben im Vergleich zu zwangsgelöschten Thyristoren kürzere Schaltzeiten und erlauben daher höhere Schaltfrequenzen. Sie können vorteilhaft in Gleichstromstellern, Gleichspannungswandlern, Wechselrichtern und Antriebsumrichtern eingesetzt werden und erlauben eine Steuerung des Energieflusses zwischen einer fast konstanten Gleichspannungsquelle und Verbrauchern mit variabler Gleich- und Wechselspannung.

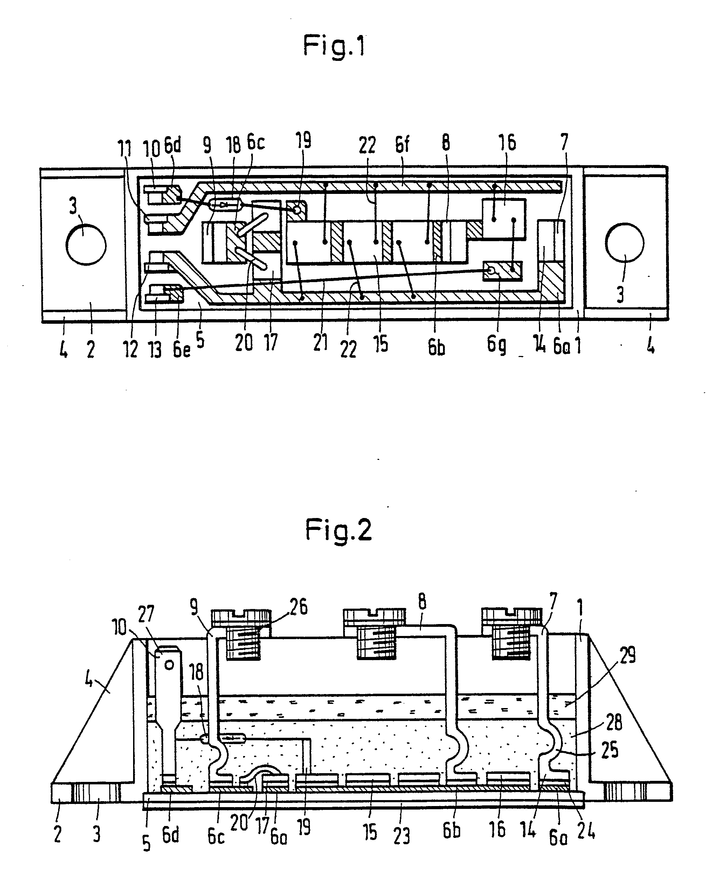

Zur Ansteuerung von Leistungstransistoren ist eine elektrische Verbindung zum Kollektoranschluß des Leistungstransistors sinnvoll, wie beispielsweise aus « Lamboley, Intelligenter Baustein steuert und schützt Leistungstransistor », Elektronik 16/13.8.1982, Seite 27 bis 29, Figuren 1 und 5 ersichtlich ist. Im bekannten Fall wird ein integrierter Baustein zur Überwachung und Steuerung der Schaltvorgänge des Leistungstransistors eingesetzt. Der Einsatz eines solchen integrierten Bausteines wird jedoch erschwert, da zwischen dem Anschluß des Leistungstransistor-Moduls an den integrierten Baustein noch die Hilfsdiode als Einzel-Bauteil eingebaut werden muß.

Der Erfindung liegt davon ausgehend die Aufgabe zugrunde, ein Leistungstransistor-Modul der eingangs genannten Art anzugeben, das zum direkten Anschluß an zur Ansteuerung dienende integrierte Bausteine geeignet ist.

Diese Aufgabe wird durch die im Anspruch 1 gekennzeichneten Merkmale gelöst.

Die mit der Erfindung erzielbaren Vorteile bestehen insbesondere darin, daß durch den Einbau der Hilfsdiode im Modul die zwischen den Hilfsanschlüssen des Moduls, wie Hilfsanschluß für den Emitter, Hilfsanschluß für den Kollektor und Basisanschluß, bestehende Spannung sehr gering ist, was eine enge Anordnung der Hilfsanschlüsse und damit einen kompakten Aufbau des Modules ermöglicht.

Vorteilhafte Ausgestaltungen der Erfindung sind in den Unteransprüchen ersichtlich.

Ein Ausführungsbeispiel der Erfindung ist nachfolgend anhand der Zeichnungen erläutert.

Es zeigen :

Figur 1 eine Aufsicht auf ein aufgeschnittenes Leistungstransistor-Modul,

Figur 2 einen Schnitt durch die Breitseite eines Moduls,

Figur 3 die interne Verschaltung der einzelnen Bauteile im Inneren des Moduls,

Figur 4 eine Variante bei der internen Verschaltung im Modul.

In Fig. 1 ist eine Aufsicht auf ein aufgeschnittenes Leistungstransistor-Modul dargestellt. Das Modul besitzt einen schmalen, rechteckförmigen, oben und unten offenen Rahmen 1, der als Gehäusewandung dient. Der Rahmen 1 weist an seinen beiden Schmalseiten in Höhe der Bodenfläche Befestigungslaschen 2 mit Bohrungen 3 zur Montage des Moduls auf einem Kühlkörper auf. Zur Erhöhung der Stabilität sind Versteifungskanten zwischen den Befestigungslaschen 2 und dem Rahmen 1 vorgesehen.

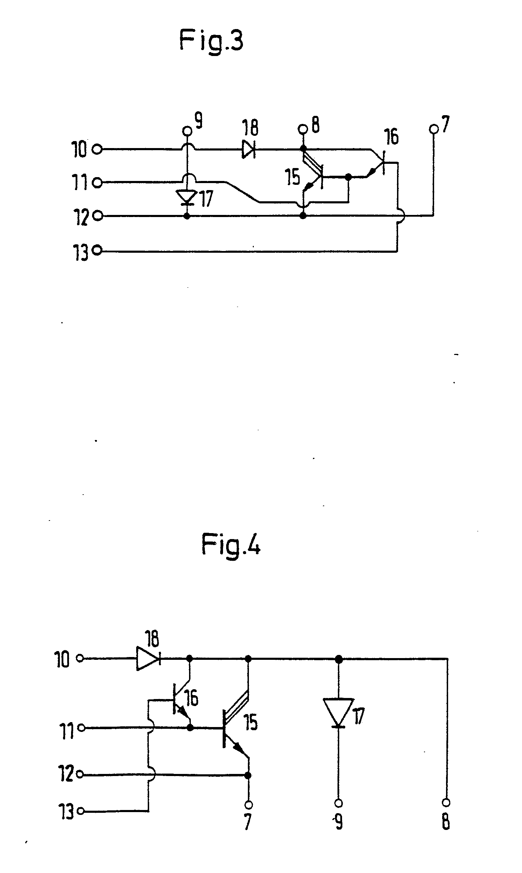

Das Gehäuse des Leistungstransistor-Moduls wird zum einen durch den Rahmen 1, zum anderen durch eine in eine Vertiefung der Bodenfläche des offenen Rahmens 1 aufgeklebte Keramikplatte 5 gebildet (siehe hierzu auch Fig. 2). Die Keramikplatte 5 weist Metallisierungen in schaltungsgemäßer Struktur (siehe Fig. 3) auf ihrer dem Gehäuseinneren zugewandten Fläche auf. Diese Metallisierungen werden beispielsweise durch Kupferfolien realisiert, die gemäß einem aus der EP-A-0 049 007 bekannten Verfahren direkt und ohne Zwischenschicht wie Lot oder Klebstoff auf die Keramikplatte 5 aufgebracht sind. Im einzelnen sind eine Emitter-Metallisierung 6a, eine Kollektor-Metallisierung 6b, eine Stützpunkt-Metallisierung für eine Freilauf-Dioden-Anode 6c, eine Metallisierung 6d für den Hilfsanschluß des Kollektors, eine Basis-1-Metallisierung 6e, eine Basis-2-Metallisierung 6f und eine Basis-1-Stützpukt-Metallisierung 6g vorgesehen.

Die genannten Metallisierungen dienen als Leiterbahnen und Kontaktflächen zum Auflöten von extern zugänglichen Anschlußelementen, Leistungstransistoren, einem Treiber-Transistor, Freilaufdioden und internen Kontaktstiften und Verbindungsdrähten. Die Emitter- bzw. Kollektor- bzw. Freilaufdioden-Anoden-Metallisierungen 6a bzw. 6b bzw. 6c sind mit den Hauptanschlüssen 7 bzw. 8 bzw. 9 für den Emitter bzw. den Kollektor bzw. die Freilaufdiode verlötet. Die Kollektor-Hilfsanschluß- bzw. Basis-2-, bzw. Emitter-, bzw. Basis-1-Metallisierungen 6d bzw. 6f bzw. 6a bzw. 6e sind mit den Hilfsanschlüssen 10 bzw. 11 bzw. 12 bzw. 13 für den Kollektor bzw. die Basis 2 und den Emitter bzw. die Basis 1 verlötet. Die genannten sieben extern an der Gehäuseoberseite zugänglichen Anschlußelemente besitzen zur mechanischen Stabilisierung der Lötstellen jeweils ein verbreitertes Fußteil 14.

Mit der Kollektor-Metallisierung 6b sind die Kollektoren von drei parallelgeschalteten Leistungstransistoren 15 verlötet. Zur Bildung einer Darlington-Schaltung ist der Kollektor eines Treiber-Transistors 16 ebenfalls mit der Metallisierung 6b verlötet. Mit der Emitter-Metallisierung 6a sind die Kathoden von zwei parallelgeschalteten Freilaufdioden 17 verlötet.

Zur Bildung des Kollektor-Hilfsanschlusses 10 ist eine Hilfsdiode 18 zwischen Kollektor-Hilfsanschluß-Metallisierung 6d und Kollektor-Metallisierung 6b angeschlossen. Die als Axialdiode ausgebildete Hilfsdiode 18 ist dabei kathodenseitig mit einem Kontaktstift 19 und anodenseitig mit dem Anschluß 10 verlötet oder punktgeschweißt. Die Kontaktstifte 19 selbst sind durch Löten mit den entsprechenden Metallisierungen verbunden.

Die Stützpunkt-Metallisierung 6c wird über verlötete Kontaktbügel 20 oder durch Ultraschall-Bonden von Aluminium-Draht mit den Anoden der Freilauf-Dioden 17 verbunden. Ein weiterer Kontaktstift 19 ist mit der Basis-1-Stützpunkt-Metallisierung des Treiber-Transistors 6g verbunden, er dient zum Anschluß eines Verbindungsdrahtes 21 zum Basis-1-Anschluß 13. Die Anschlüsse der Basis-Elektroden bzw. der Emitter-Elektroden der Leistungstransistoren 15 an die Basis-2-Metallisierungen 6f bzw. die Emitter-Metallisierungen 6a werden durch Verbindungsdrähte 22 bewerkstelligt. Gleichartige Verbindungsdrähte 22 dienen auch zum Anschluß des Emitters bzw. der Basis des Treiber-Transistors 16 an die Basis-2-Metallisierung 6f bzw. die Basis-1-Stützpunkt-Metallisierung 6g. Die Verbindungsdrähte 22 sind vorzugsweise aus Aluminium und gebondet (Ultraschallbonden).

In Fig. 2 ist ein Schnitt durch die Breitseite eines Leistungstransistor-Moduls dargestellt. Es ist insbesondere das aus dem Rahmen 1 und der Keramikplatte 5 bestehende Modulgehäuse mit den angeformten Befestigungslaschen 2 und Versteifungskanten 4 ersichtlich. Die Keramikplatte 5 weist neben den inneren strukturierten Metallisierungen 6a bis 6g auch eine Metallisierung 23 auf der Außenseite auf. Die Metallisierung 23 dient zur Erhöhung der Stabilität der Keramikplatte 5. Die Lotschicht zwischen der inneren Metallisierung 6a bis 6g und den aufgelöteten Bauteilen ist mit 24 bezeichnet.

Insbesondere geht aus Fig. 2 der Aufbau der Haupt- und Hilfsanschlüsse hervor. An das verbreiterte Fußteil 14 der Hauptanschlüsse 7, 8, 9 schließen sich eine Abwinkelung und ein Dehnungsbogen 25 an. Der Dehnungsbogen 25 ist in seinem Querschnitt kleiner als der Querschnitt des übrigen Anschlußelementes und dient zum Abfangen von Zugspannungen auf die Lötverbindung zwischen Fußteil 14 und innerer Metallisierung. An seinem oberen Ende geht der Dehnungsbogen in eine Abwinkelung mit Gewindebohrung 26 zur Bildung eines Schraubanschlusses über. Die Hilfsanschlüsse 10 bis 13 sind vorzugsweise als Flachstecker 27 mit oder ohne Dehnungsbogen 25 ausgebildet.

Aus Fig. 2 sind desweiteren der Anschluß der Hilfsdiode 18 sowie die Kontaktierung der Anode der Freilaufdiode 17 über den aufgeschobenen Kontaktbügel 20 dargestellt.

Die mit den Halbleiterbauelementen und internen wie externen Anschlußelementen bestückte Keramikplatte 5 wird mit dem Gehäuse verklebt. Anschließend wird das Gehäuse im unteren Teil mit einer weichen Vergußmasse (z. B. Silikonkautschuk) 28 zum Schutz der empfindlichen Aktivteile und Lötverbindungen vergossen. Das Verschließen des Gehäuses bis knapp über die Gehäusemitte erfolgt mit einer harten Vergußmasse (z. B. Expoxidharz). Durch die harte Vergußmasse 29 werden die extern zugänglichen Anschlußelemente mechanisch stabilisiert. Der obere Gehäuseteil bleibt zum externen Anschluß des Moduls frei von Vergußmasse und kann mittels eines die Anschlüsse aussparenden Deckels abgedeckt sein.

Neben dem beschriebenen Anschluß der Hilfsdiode 18 über Kontaktstifte 19 kann die Diode auch direkt auf eine vorgesehene Metallisierung auf der Keramikplatte 5 aufgelötet werden. Ferner sind auch Flachstecker für die Hauptanschlüsse anstelle der beschriebenen Schraubanschlüsse möglich.

In Fig. 3 ist die innere Verschaltung der einzelnen Bauteile im Inneren des Modules dargestellt. Der Emitter-Anschluß 7 ist mit den Emittern der Leistungstransistoren 15, mit den Kathoden der Freilaufdioden 17 und mit dem Emitter-Hilfsanschluß 12 verbunden. An den Kollektor-Anschluß 8 sind die Kollektoren der Leistungstransistoren 15 und des Treiber-Transistors 16 sowie die Kathode der Hilfsdiode 18 angeschlossen. Am Freilaufdioden-Anschluß 9 liegen die Anoden der Freilaufdioden 17. Der Kollektor-Hilfsanschluß 10 ist mit der Anode der Hilfsdiode 18 verbunden. An den Basis-2-Anschluß 11 sind die Basis-Elektroden der Leistungstransistoren 15 und der Emitter des Treiber-Transistors 16 angeschlossen. Am Basis-1-Anschluß 13 liegt die Basis des Treiber-Transistors 16.

In Fig. 4 ist eine Variante bei der internen Verschaltung im Modul anhand eines Schaltbildes dargestellt. Hierbei ist die Freilaufdiode 17 anodenseitig mit dem Kollektor des Transistors 15, der Kathode der Hilfsdiode 18, dem Kollektor des Treibertransistors 16 und dem Anschluß 8 sowie kathodenseitig mit dem Anschluß 9 verbunden.

Die Schaltungen nach Fig. 3 und 4 werden paarweise zum Aufbau von Transistor-Halbbrücken benötigt. Die gezeigte Reihenfolge der nach außen geführten Anschlüsse 7, 8 und 9 ermöglicht einfache Zusammenschaltungen durch Verschienen. Der Abgriff 7 gem. Fig. 3 und 8 gemäß Fig. 4 zwischen Diode 17 und Transistor 15 ist stets außen gegenüber den Hilfsanschlüssen 10 bis 13 am Modul angeordnet, so daß der Anschluß für zusätzliche Schaltungselemente (z. B. Induktivitäten) leichter zugänglich ist.

## Patentansprüche

1. Leistungstransistor-Modul mit einem Kunststoff-Rahmen (1) als Gehäusewandung und einer Keramikplatte (5) als Gehäuseboden, die über als Leiterbahnen und Anschlußflächen dienende strukturierte Metallisierungen mit einem bzw. mehreren Leistungstransistoren (15) bzw. Freilaufdioden (17) sowie mit auf der Gehäuseoberseite frei zugänglichen Anschlußelementen versehen ist, dadurch gekennzeichnet, daß ein Kollektor-Hilfsanschluß (10) vorgesehen ist, der über eine Hilfsdiode (18) mit dem Kollektor des Leistungstransistors (15) verbunden ist.

2. Leistungstransistor-Modul nach Anspruch 1, dadurch gekennzeichnet, daß weitere Hilfsanschlüsse (11, 12, 13) zur Bildung von Basisanschlüssen und Emitter-Hilfsanschlüssen vorgesehen sind.

3. Leistungstransistor-Modul nach einem der vorhergehenden Ansprüche, dadurch gekennzeichnet, daß außer den an der Gehäuseoberseite angeordneten Hilfsanschlüssen (10, 11, 12, 13) auch ein gemeinsamer Leistungstransistor-Freilaufdiodenanschluß an der Gehäuseoberseite, jedoch in der Nähe der den Hilfsanschlüssen gegenüberliegenden Seitenkante angeordnet ist.

**Claims**

1. Power transistor module comprising a plastic frame (1) as housing wall and a ceramic plate (5) as housing bottom, which is provided, via structured metallisations serving as conductor tracks and connecting surfaces, with one or more power transistors (15) and freewheeling diodes (17) and with connecting members which are freely accessible at the top of the housing, characterised in that an auxiliary collector connection (10) is provided which is connected *via* an auxiliary diode (18) to the collector of the power transistor (15).

2. Power transistor module according to Claim 1, characterised in that other auxiliary connections (11, 12, 13) are provided for forming base connections and auxiliary emitter connections.

3. Power transistor module according to one of the preceding claims, characterised in that, in addition to the auxiliary connections, (10, 11, 12, 13) arranged at the top of the housing, a common power transistor — free-wheeling diode connection is also arranged at the top of the housing but in the vicinity of the side edge located opposite to the auxiliary connections.

**Revendications**

1. Module de transistors de puissance avec, comme paroi de boîtier, un cadre (1) de matière plastique et, comme fond de boîtier, une plaque (5) de céramique qui, sur des métallisations structurées servant de bandes conductrices et de surfaces de raccordement, est équipée d'un ou plusieurs transistors de puissance (15) et diodes roue-libre (17), ainsi que d'éléments de connexion librement accessibles sur la face supérieure du boîtier, caractérisé par le fait qu'est prévue une connexion auxiliaire de collecteur (10), laquelle est reliée, par une diode auxiliaire (18), au collecteur du transistor de puissance (15).

2. Module de transistors de puissance selon la revendication 1, caractérisé par le fait que d'autres connexions auxiliaires (11, 12, 13) sont prévues pour la constitution de connexions de base et de connexions auxiliaires d'émetteur.

3. Module de transistors de puissance selon l'une quelconque des revendications précédentes, caractérisé par le fait que, outre les connexions auxiliaires (10, 11, 12, 13) disposées sur la face supérieure du boîtier, une connexion commune de transistors de puissance et de diodes roue-libre est disposée sur la face supérieure du boîtier, mais au voisinage de l'arête latérale opposée aux connexions auxiliaires.

# Fig.1

# Fig.2

# Fig.3

# Fig.4